# FASCICULE DE BREVET EUROPEEN

(11) **EP 3 019 886 B1**
(45) Date de publication et mention de la délivrance du brevet: **23.12.2020**
(21) Numéro de dépôt: 14739758.2
(22) Date de dépôt: 09.07.2014
(51) Int. Cl.: G01R 33/60, G01T 1/04

(54) **DOSIMETRE DE RADIATION ET PROCEDE DE MESURE DE DOSE PAR SPECTROSCOPIE RPE**
STRAHLUNGSDOSIMETER UND DOSISMESSVERFAHREN DURCH EPR-SPEKTROSKOPIE
RADIATION DOSIMETER AND DOSE MEASUREMENT METHOD BY EPR SPECTROSCOPY

(30) Priorité: 09.07.2013 FR 1356748
(43) Date de publication de la demande: 18.05.2016
(73) Titulaire: Institut de Radioprotection et de Sûreté Nucléaire, 92260 Fontenay aux Roses (FR); Commissariat à l'Énergie Atomique et aux Énergies Alternatives, 75015 Paris (FR)
(72) Inventeur: GARCIA, Tristan, F-75011 Paris (FR); TROMPIER, François, F-92260 Fontenay Aux Roses (FR)
(74) Mandataire: Regimbeau
(86) Numéro de dépôt international: PCT/EP2014/064697
(87) Numéro de publication internationale: WO 2015/004176

(56) Documents cités:
- TRISTAN GARCIA ET AL: "Dose verification and calibration of the Cyberknifeby EPR/alanine dosimetry", RADIATION MEASUREMENTS, ELSEVIER, AMSTERDAM, NL, vol. 46, no. 9, 28 mars 2011 (2011-03-28), pages 952-957, XP028291550, ISSN: 1350-4487, DOI: 10.1016/J.RADMEAS.2011.03.031 [extrait le 2011-04-07]
- SCHAEKEN B ET AL: "Implementation of alanine/EPR as transfer dosimetry system in a radiotherapy audit programme in Belgium", RADIOTHERAPY AND ONCOLOGY, ELSEVIER, IRELAND, vol. 99, no. 1, 31 janvier 2011 (2011-01-31), pages 94-96, XP028193901, ISSN: 0167-8140, DOI: 10.1016/J.RADONC.2011.01.026 [extrait le 2011-02-17]
- CHEN ET AL: "Response of l-alanine and 2-methylalanine minidosimeters for K-Band (24GHz) EPR dosimetry", NUCLEAR INSTRUMENTS & METHODS IN PHYSICS RESEARCH, SECTION - B:BEAM INTERACTIONS WITH MATERIALS AND ATOMS, ELSEVIER, AMSTERDAM, NL, vol. 264, no. 2, 20 septembre 2007 (2007-09-20), pages 277-281, XP022339847, ISSN: 0168-583X, DOI: 10.1016/J.NIMB.2007.08.097
- AL-KARMI A M ET AL: "EPR of gamma-irradiated polycrystalline alanine-in-glass dosimeter", RADIATION MEASUREMENTS, ELSEVIER, AMSTERDAM, NL, vol. 43, no. 7, 1 août 2008 (2008-08-01), pages 1315-1318, XP023784578, ISSN: 1350-4487, DOI: 10.1016/J.RADMEAS.2008.04.088 [extrait le 2008-04-29]
- ANAN M. AL-KARMI: "Dosimetric evaluation of alanine-in-glass dosimeters at clinical dose levels using high-energy X-rays from a linear accelerator", RADIATION MEASUREMENTS, vol. 45, no. 1, 1 janvier 2010 (2010-01-01), pages 133-135, XP055106906, ISSN: 1350-4487, DOI: 10.1016/j.radmeas.2009.10.063
- FRANÇOIS TROMPIER ET AL: "Radiation-induced signals analysed by EPR spectrometry applied to fortuitous dosimetry", ANNALI DELL'ISTITUTO SUPERIORE DI SANITÀ, vol. 45, no. 3, 4 août 2009 (2009-08-04), pages 287-296, XP055106844,
- TROMPIER F ET AL: "Radiation accident dosimetry on plastics by EPR spectrometry", HEALTH PHYSICS, vol. 98, no. 2, 1 février 2010 (2010-02-01), pages 388-394, XP009176812, ISSN: 1538-5159, DOI: 10.1097/01.HP.0000346334.78268.31
- BASSINET C ET AL: "Radiation accident dosimetry on glass by TL and EPR spectrometry", HEALTH PHYSICS, vol. 98, no. 2, 1 février 2010 (2010-02-01), pages 400-405, XP009176842, ISSN: 1538-5159, DOI: 10.1097/01.HP.0000346334.72296.51

## Description

### DOMAINE DE L'INVENTION

Le domaine de l'invention est celui de la dosimétrie des rayonnements ionisants, par spectroscopie par résonance paramagnétique électronique (ou spectroscopie RPE). Plus spécifiquement, l'invention concerne un dispositif de mesure passif (dosimètre passif ou à lecture différée) pour l'estimation des doses (dosimétrie) de rayonnements ionisants pour la spectroscopie RPE et un procédé de dosimétrie avec un tel dosimètre.

### ETAT DE LA TECHNIQUE

La spectroscopie RPE est une technique de mesure utilisée pour l'estimation de la dose déposée dans un matériau après une irradiation avec des rayonnements ionisants, c'est-à-dire après l'interaction des rayonnements ionisants (photons, électrons, protons, neutrons, particules a, etc.) avec le matériau.

Cette technique est appliquée sur des matériaux pour lesquels l'interaction des rayonnements ionisants avec la matière génère des entités paramagnétiques du type radicaux libres (c'est-à-dire des espèces chimiques comprenant au moins un électron non apparié), défauts ou ions en quantité proportionnelle à la dose déposée dans le matériau considéré.

Au cours d'une mesure d'un matériau par spectroscopie RPE, on place le matériau dans un champ magnétique, provoquant l'alignement selon le champ des moments magnétiques des entités paramagnétiques contenues dans le matériau dosimétrique en deux proportions non identiques selon le sens de rotation des électrons non appariés (sens parallèle ou antiparallèle au champ magnétique). Ces sens d'orientation des moments magnétiques des dits électrons correspondant à des niveaux d'énergie différents, il en résulte une différence d'énergie entre les deux niveaux d'énergie.

Perpendiculairement au champ magnétique, on soumet également le matériau à un rayonnement électromagnétique (type micro-ondes par l'intermédiaire d'un klystron).

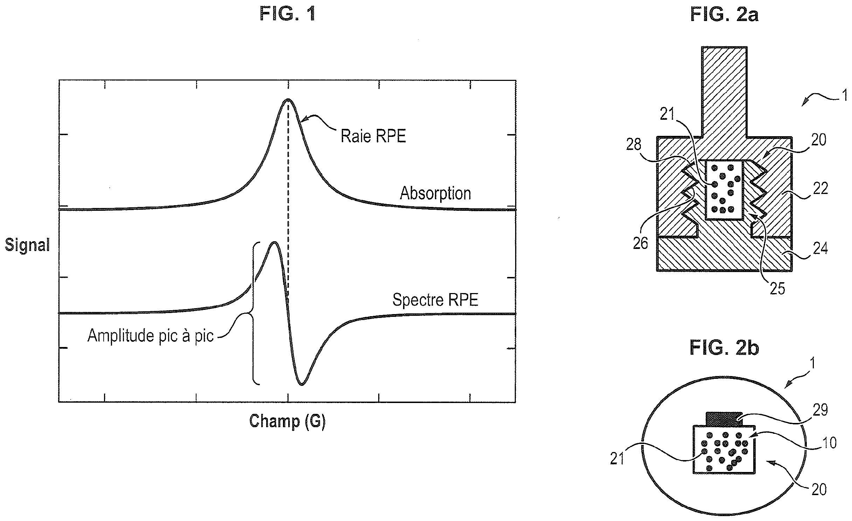

Le phénomène de résonance est atteint lorsque l'énergie apportée par le rayonnement électromagnétique émis est égale à la différence d'énergie entre les deux niveaux d'énergie des entités paramagnétiques. Cette résonance entraîne le va-et-vient des électrons non appariés d'un niveau d'énergie à l'autre. L'absorption d'énergie nécessaire à ces transitions est quantifiée par le spectromètre RPE. De manière courante, le spectre RPE, ou signal RPE, enregistré est la dérivée du signal d'absorption (figure 1).

Pour relier la dose délivrée dans le matériau à l'intensité de l'absorption RPE, plusieurs approches peuvent être utilisées. On peut par exemple, utiliser l'aire sous l'intégrale du signal mesuré, ou encore l'amplitude entre le maximum et le minimum (dite amplitude « pic-à-pic ») de la dérivée première du pic d'absorption, également appelé raie RPE, lié à l'espèce paramagnétique induite par l'irradiation. En effet, le nombre d'espèces paramagnétiques radio-induites (c'est-à-dire induite par les radiations) est fonction de la dose absorbée.

Par conséquent, en mesurant par exemple l'amplitude pic-à-pic de la dérivée du spectre d'absorption, on peut en déduire la dose déposée dans le matériau en utilisant l'une des deux méthodes suivantes.

La première méthode consiste à construire une ou plusieurs courbes d'étalonnage reliant l'amplitude à des doses connues d'irradiation à partir d'échantillons semblables à ceux utilisés ensuite pour l'estimation de la dose. Ces échantillons sont irradiés à des doses connues. Le signal d'absorption des différents échantillons est alors mesuré et enregistré avec des paramètres de mesure identiques et dans des conditions similaires (conditions environnementales). La valeur de l'amplitude pic-à-pic de la raie d'absorption RPE par exemple de ces différents échantillons permet alors d'établir une courbe reliant l'amplitude à la dose.

Pour établir la courbe d'étalonnage, on utilise une gamme de doses couvrant l'ensemble des doses à évaluer. En outre, pour appliquer ces doses au matériau d'étalonnage, il faut utiliser un faisceau dont le débit de dose est connu et dont le spectre d'énergie correspond autant que possible à celui du rayonnement auquel ont été exposés les dosimètres à évaluer. En effet, pour une dose fixée, la quantité d'espèces radio-induites peut différer en fonction du rayonnement et du débit de dose utilisés.

Le matériau utilisé comme dosimètre doit présenter dans la mesure du possible un rendement radiolytique élevé, c'est-à-dire que la quantité d'espèces paramagnétiques générées par unité de dose ou d'énergie déposée doit être élevée, afin que les signaux RPE radio-induits soient aisément mesurés. Il est nécessaire d'avoir une relation de proportionnalité entre la dose absorbée et le nombre d'espèces paramagnétiques induites si possible sur une large gamme de doses. Il est préférable que le rendement radiolytique soit indépendant de l'énergie du faisceau d'irradiation et du type de rayonnement, et indépendant du débit de dose. C'est le cas par exemple de l'alanine, un acide aminé dont l'utilisation est courante en dosimétrie des rayonnements ionisants par spectroscopie RPE dans les laboratoires nationaux de métrologie des rayonnements ionisants.

La seconde méthode est applicable aux matériaux pour lesquels le rendement radiolytique peut être très variable d'un échantillon à l'autre, comme par exemple les tissus osseux ou les minéraux. Pour ces matériaux, pour estimer les dose absorbées dans les matériaux, on utilise la méthode dite des « ajouts dosés », qui consiste à établir une relation entre l'intensité de l'absorption liée aux espèces paramagnétiques radio-induites et la dose absorbée dans l'échantillon étudié.

Pour cet échantillon, on réalise une première série de mesures de spectres RPE, puis on irradie l'échantillon à des doses connues supplémentaires, et après chaque irradiation on réalise une nouvelle série de mesures pour déterminer son coefficient de sensibilité, c'est-à-dire la variation de l'intensité de l'absorption par rapport à la variation de dose.

Ce coefficient est ensuite utilisé pour convertir en termes de dose absorbée l'intensité de l'absorption enregistrée avant le processus de post-irradiation. Les mesures sont réalisées dans les mêmes conditions expérimentales et avec les mêmes paramètres de mesure.

La spectroscopie RPE présente de nombreuses applications telles que la datation d'échantillons archéologiques à partir de la dose accumulée par irradiation naturelle, l'estimation de la dose reçue lors d'accidents radiologiques à partir de biopsies pratiquées sur les victimes ou de matériaux portés par celles-ci ou provenant de leur environnement direct, l'identification de produits alimentaires irradiés, l'estimation de la dose reçue par des individus lors d'une exposition chronique et/ou ancienne, à partir de biopsies d'émail dentaire, ou encore l'étalonnage et le contrôle des sources de rayonnement.

Elle peut être également utilisée pour vérifier le niveau de dose absorbée par un objet que l'on cherche à stériliser par irradiation.

Un matériau dosimétrique couramment utilisé pour la mesure de dose par spectroscopie RPE est l'alanine ; il s'agit d'un acide aminé dont les espèces paramagnétiques radio-induites présentent l'avantage d'une grande stabilité dans le temps dans les conditions normales de température et d'humidité, c'est-à-dire que l'intensité du spectre RPE après irradiation est stable sur plusieurs mois voire années. En outre, l'alanine étant un des 20 acides aminés présents chez les êtres vivants, la réponse aux rayonnements ionisants de l'alanine est proche de celle d'un tissu biologique, ce qui implique par exemple pour les photons un rendement radiolytique quasi indépendant de l'énergie des photons (dans une gamme d'énergie étendue (de quelques centaines de keV à quelques MeV) lorsque les références dosimétriques sont données en termes de dose dans le tissu.

A ce jour, l'alanine est utilisée en routine pour les irradiations industrielles:
- Agroalimentaire : hygiénisation/stérilisation - public - malades immunodéficients
- Produits à usage unique : stérilisation (prothèses, gants, seringues,...)
- Médicaments : stérilisation (issus des biotechnologies ou thermosensibles)
- Matériaux : tenue à l'irradiation, vieillissement.

Le document par AL-KARMI A M ET AL, "EPR of gamma-irradiated polycrystalline alanine-in-glass dosimeter", RADIATION MEASUREMENTS, vol. 43, no. 7, 4 april 2008, pages 1315-1318, divulgue par exemple l'utilisation de dosimètres constitués d'alanine placée dans des tubes en verre pour la mesure de dose par spectroscopie RPE.

L'alanine est aussi utilisée notamment pour contrôler les niveaux de dose reçus au cours d'une irradiation par un traitement médical de type radiothérapie ou en radiobiologie lors de l'irradiation de petits animaux ou autres échantillon biologiques.

Pour ce faire, des pastilles d'alanine, comprenant une poudre d'alanine, mélangée à un ou plusieurs excipients permettant de lui conférer une forme stable, sont déposées dans un conteneur dédié, qui est positionné dans une cuve ou un mannequin reproduisant l'épaisseur de tissu à traverser par le faisceau ionisant pour parvenir à une tumeur à traiter. L'alanine est ensuite irradiée par le faisceau, puis les pastilles sont récupérées et placées dans des tubes en verre pour réaliser la mesure de dose par spectroscopie RPE.

Or, les faisceaux ionisants utilisés dans les traitements de radiothérapie et de radiochirurgie sont de plus en plus petits, pour permettre un traitement de plus en plus précis. Le faisceau peut en effet être limité à un diamètre de l'ordre du millimètre, voire moins. Les pastilles d'alanine actuellement utilisées étant d'un diamètre de quelques millimètres, elles ne permettent pas d'intégrer la dose délivrée par le faisceau sur l'ensemble de sa géométrie.

Il existe donc un besoin pour proposer un dosimètre dont la géométrie est adaptée aux dimensions des faisceaux utilisés en radiothérapie.

Or, des efforts ont été déployés pour réaliser des pastilles d'alanine de taille réduite. Cependant la présence d'un excipient devient problématique à de telles dimensions : en effet, la quantité de poudre d'alanine contenue dans chaque pastille étant d'autant plus faible qu'elle est liée par l'excipient, la mesure est moins précise et moins sensible. De plus, la plupart des excipients présentent des signaux RPE parasites que ce soit avec ou sans irradiation. En outre, la poudre d'alanine est répartie de manière hétérogène dans la pastille, ce qui peut dégrader la reproductibilité des mesures.

Enfin, les pastilles d'alanine de dimensions réduites sont très fragiles, leur manipulation est donc difficile et présente en outre un risque de perdre une partie du matériau dosimétrique irradié, ce qui dégrade encore la qualité de la mesure, car il faudra alors corriger les mesures de la différence de masse entre les pastilles cassées et celles restées intègres.

Les solutions déjà proposées n'ont donc pas réussi à atteindre un compromis entre taille du dosimètre et précision de la mesure et de l'estimation des doses.

### PRESENTATION DE L'INVENTION

L'invention a pour but de pallier le problème précité. En particulier, l'invention a pour objet de proposer un dosimètre dont les dimensions peuvent être réduites pour être adaptées à une utilisation en radiothérapie et radiochirurgie, sans dégrader la qualité de la mesure.

Un autre but de l'invention est de proposer un dosimètre permettant de s'affranchir de l'excipient utilisé pour confiner le matériau dosimétrique.

Un but de l'invention est encore de proposer un dosimètre dont la géométrie peut être modulée en fonction de son application.

Un autre but de l'invention est de proposer un dosimètre de manipulation aisée.

Un autre but de l'invention est qu'elle puisse s'appliquer aussi pour les autres domaines de la dosimétrie des rayonnements ionisants en particulier en contexte industriel.

A cet égard, l'invention a pour objet un dosimètre de radiations pour spectroscopie RPE, tel que défini dans la revendication indépendante 1, comprenant une quantité de matériau dosimétrique, le dosimètre étant adapté pour être irradié et subir une mesure de dose par spectroscopie RPE. Des modes de réalisation avantageux sont définis dans les revendications dépendant de la revendication 1.

L'invention concerne également un procédé de mesure par spectroscopie RPE d'une dose absorbée par une quantité de matériau dosimétrique contenue dans un tel dosimètre, ainsi que défini dans la revendication indépendante 10. Des modes de réalisation avantageux sont définis dans les revendications dépendant de la revendication 10.

L'invention concerne enfin l'utilisation d'un procédé d'étalonnage pour étalonner un dosimètre conforme à la description qui précède, comprenant l'irradiation du dosimètre à une pluralité de doses connues, et la mise en œuvre, à chaque irradiation, d'une mesure par spectroscopie RPE de l'intensité du signal RPE du dosimètre, pour établir une relation entre la valeur de l'amplitude dudit signal et la dose reçue.

L'invention a également pour objet un procédé de fabrication d'un dosimètre, comprenant la formation d'une enveloppe en une ou deux parties par moulage, injection ou usinage, l'insertion de matériau dosimétrique dans une partie de l'enveloppe et la fermeture hermétique de l'enveloppe.

Le dosimètre proposé par l'invention permet de mesurer une dose absorbée par le matériau dosimétrique contenu dans le dosimètre après une irradiation de celui-ci, sans extraire ledit matériau du dosimètre. En effet, il est possible, après que le dosimètre ait été irradié à une dose inconnue, de déduire d'une mesure par spectroscopie RPE du dosimètre complet la dose absorbée par le matériau dosimétrique qu'il contient.

Ceci présente de nombreux avantages. En premier lieu, il n'est plus nécessaire de manipuler le matériau dosimétrique contenu dans le dosimètre pour le transvaser depuis le dosimètre jusqu'à un support pour la mesure de spectroscopie.

On évite ainsi de perdre une quantité de matériau dosimétrique et de dégrader la qualité des mesures.

En outre, il est possible d'utiliser le matériau dosimétrique sous forme pure, c'est-à-dire dépourvu d'excipient, puisque le matériau dosimétrique peut être placé sous forme pulvérulente par exemple dans l'enveloppe du dosimètre.

Ceci permet en particulier de modifier à volonté la géométrie du dosimètre, et en particulier d'en réduire les dimensions, sans dégrader la qualité de la mesure. Notamment, dans le cas de l'utilisation de l'alanine comme matériau dosimétrique, il est possible d'utiliser l'alanine sous forme pulvérulente, et on peut donc s'affranchir de l'utilisation de pastilles pouvant présenter des dimensions trop élevées par rapport aux utilisations désirées.

Par ailleurs, de nombreuses applications peuvent être envisagées pour utiliser le dosimètre proposé, qui sont décrites plus en détails par la suite.

### DESCRIPTION DES FIGURES

D'autres caractéristiques, buts et avantages de l'invention ressortiront de la description qui suit, qui est purement illustrative et non limitative, et qui doit être lue en regard des dessins annexés sur lesquels :
- La figure 1, déjà décrite, représente un exemple de spectre d'absorption de matériau dosimétrique et sa dérivée,
- La figure 2a représente un exemple de dosimètre de radiations selon un mode de réalisation de l'invention,
- La figure 2b représente un autre exemple de dosimètre de radiations,
- La figure 3a représente l'évolution de l'amplitude de spectre RPE d'un matériau à réponse spectrométrique décroissante après une irradiation,
- La figure 3b représente l'évolution de l'amplitude de spectre RPE d'un matériau à réponse spectrométrique constante après une irradiation,
- La figure 4 représente un exemple de spectre RPE d'un dosimètre de radiations selon l'invention et son évolution au cours du temps,
- La figure 5 représente les principales étapes du procédé de mesure de dose selon l'invention,
- La figure 6 représente un exemple d'installation pour la mise en oeuvre du procédé de mesure de dose.

### DESCRIPTION DETAILLEE D'AU MOINS UN MODE DE REALISATION DE L'INVENTION

### Dosimètre de radiations

En référence à la figure 2a, on a représenté un exemple de dosimètre de radiations pour spectroscopie RPE.

Ce dosimètre 1 comprend une quantité de matériau dosimétrique 10, c'est-à-dire de matériau qui, après avoir interagi avec des rayonnements ionisants (après avoir subi une irradiation), comporte des entités paramagnétiques du type radicaux libres, trous ou ions.

Ces entités paramagnétiques peuvent être étudiées par spectroscopie RPE pour déterminer la dose radioactive absorbée par le matériau dosimétrique. Pour ce faire, on réalise une mesure de dose par spectroscopie RPE du matériau dosimétrique pour obtenir un spectre RPE, et on mesure l'intensité du signal du matériau dosimétrique pour en déduire la dose absorbée.

On appelle spectre RPE ou signal RPE la dérivée du spectre ou du signal d'absorption d'énergie du matériau. Le spectre d'absorption pouvant être établi des deux manières suivantes :
- soit en soumettant le matériau à un champ magnétique constant et en lui appliquant un faisceau d'ondes électromagnétiques dont on fait varier l'énergie ou la fréquence, la dérivée du spectre est alors une dérivée par rapport à l'énergie (ou la fréquence) des ondes électromagnétiques,
- soit en soumettant le matériau à un faisceau d'ondes électromagnétiques d'énergie (et de fréquence) constante, et en lui appliquant un champ magnétique d'intensité variable, la dérivée du spectre est alors une dérivée par rapport à l'intensité du champ magnétique.

En général, c'est l'amplitude pic-à-pic de la dérivée de l'absorption qui est mesurée pour déterminer la dose absorbée par le matériau. On appelle dans la suite la dérivée de la raie d'absorption la « raie RPE ».

Le dosimètre 1 comprend en outre une enveloppe 20 fermée hermétiquement pour contenir le matériau dosimétrique. Le matériau dosimétrique 10 est intégralement contenu dans un volume 21 délimité par l'enveloppe, de manière à être confiné hermétiquement dans ledit volume.

### Réponses par spectroscopie RPE des matériaux du dosimètre de radiations

L'enveloppe 20 est constituée d'un matériau qui présente une réponse par spectroscopie RPE distincte de la réponse par spectroscopie RPE du matériau dosimétrique pour une irradiation identique, c'est-à-dire avec la même énergie, le même débit de dose et pendant la même période de temps. Par « réponse par spectroscopie RPE », on entend l'évolution temporelle de la quantité d'entités paramagnétiques générées pendant une irradiation dans le matériau.

En d'autres termes, la réponse par spectroscopie RPE est l'évolution du spectre RPE en fonction du temps écoulé après l'irradiation, à paramètres de mesure par spectroscopie RPE constants.

D'autre part, un matériau non paramagnétique, et pour lequel l'interaction avec un rayonnement ionisant ne génère aucune entité paramagnétique ne présente pas de signal RPE.

Alternativement, un matériau dosimétrique privilégié en spectroscopie RPE tel que l'alanine présente, après son irradiation, une réponse par spectroscopie RPE quasi-constante en fonction du temps, c'est-à-dire que le spectre RPE n'évolue pas après l'irradiation, à paramètres constants de la mesure. En outre l'alanine a l'avantage de présenter des caractéristiques physico-chimiques proches des tissus biologiques, elle est donc utilisée en priorité pour déterminer les doses absorbées par des tissus biologiques lors de traitement médicaux ou de simulation d'expositions accidentelles à des rayonnements ionisants.

Le fait que le matériau de l'enveloppe 20 présente une réponse par spectroscopie RPE différente, voire inexistante, de la réponse du matériau dosimétrique après une irradiation identique permet d'irradier intégralement le dosimètre 1 puis de déduire d'une mesure en spectroscopie RPE du dosimètre la dose absorbée par le matériau dosimétrique, sans devoir extraire ledit matériau pour l'analyser séparément. Ceci supprime la nécessité de manipuler le matériau dosimétrique entre l'irradiation et la mesure.

A cet égard, selon un mode de réalisation privilégié de l'invention, le matériau constitutif de l'enveloppe 20 du dosimètre ne présente pas de signal RPE après irradiation. Ainsi, la réponse du dosimètre par spectroscopie RPE après irradiation correspond uniquement à la réponse du matériau dosimétrique.

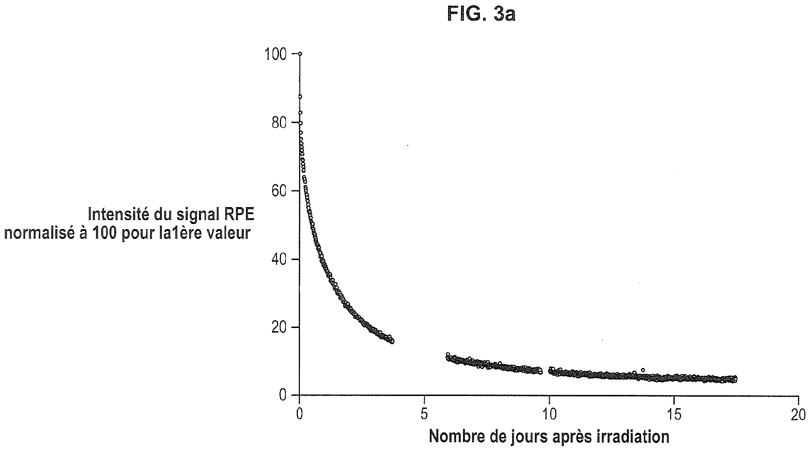

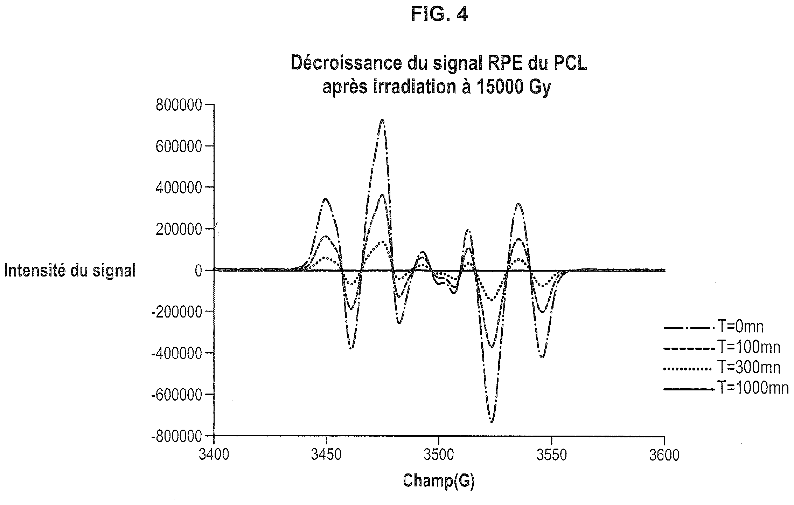

Alternativement, comme représenté en figure 3a et en figure 4, le matériau de l'enveloppe 20 présente un signal RPE dont l'intensité décroit au cours du temps après une irradiation, ce qui correspond à une disparition progressive des entités paramagnétiques générées au cours de l'irradiation.

Notamment, un signal RPE décroissant dans le temps signifie qu'il existe un laps de temps ΔT après l'irradiation au terme duquel le matériau ne présente plus de signal RPE mesurable, ou un signal résiduel dont l'intensité est inférieure à 5% de celui mesuré juste après irradiation.

La courbe représentée en figure 3a représente l'évolution à température ambiante de l'amplitude pic-à-pic de la raie RPE du polycarbonate en fonction du temps passé après une irradiation du matériau. On constate que cette amplitude est inférieure à 5% de l'amplitude initiale lors de l'irradiation environ 15 jours après l'irradiation.

La figure 4 représente la décroissance en fonction du temps du signal RPE du polycaprolactone (PCL).

Ainsi, pour obtenir la mesure en spectroscopie RPE du matériau dosimétrique contenu dans le dosimètre, il suffit d'attendre que ce laps de temps après irradiation soit écoulé ; le matériau de l'enveloppe ne perturbe alors pas la mesure.

Dans ce cas, le matériau dosimétrique doit toujours présenter un signal RPE mesurable après l'écoulement du laps de temps ΔT, ce qui est le cas dans la situation avantageuse où le matériau dosimétrique choisi présente un signal stable en fonction du temps après l'irradiation.

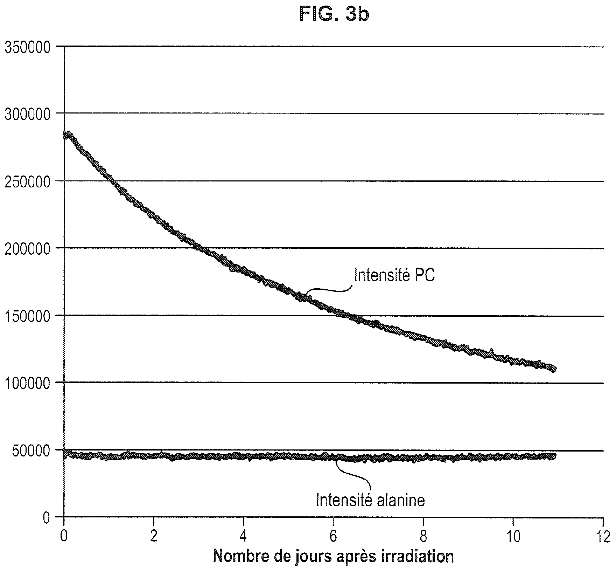

C'est le cas représenté en figure 3b, qui illustre une comparaison des amplitudes pic-à-pic des raies RPE en valeur absolue pour le polycarbonate de la figure 3a et pour l'alanine.

Avantageusement, le matériau choisi pour l'enveloppe présente un signal RPE avec une réponse décroissante telle que le polycaprolactone ou le polycarbonate.

Selon un mode de réalisation alternatif, les spectres RPE respectifs du matériau dosimétrique et du matériau de l'enveloppe après une même irradiation et un laps de temps identique après cette irradiation s'étendent sur des plages de valeurs distinctes.

Dans le cas où les raies RPE des matériaux utilisés pour l'enveloppe 20 s'étendent sur des plages de champ magnétique distinctes et avantageusement disjointes du spectre RPE du matériau dosimétrique 10, alors ces matériaux peuvent également être utilisés.

Ainsi, il suffit d'adapter les paramètres du champ magnétique et/ou de la fréquence des ondes électromagnétiques pour que ces paramètres correspondent à la sélection permettant d'obtenir le spectre RPE du matériau dosimétrique. On obtient ainsi ce spectre, qui n'est pas perturbé par le spectre du matériau de l'enveloppe puisque ce dernier se trouve sur une plage de valeurs distincte.

La condition sur les caractéristiques spectrométriques du matériau de l'enveloppe et du matériau dosimétrique étant fixée, de nombreuses possibilités sont offertes concernant le choix des matériaux.

Concernant le matériau dosimétrique d'une part, il est avantageusement choisi parmi les matériaux privilégiés pour la dosimétrie par spectroscopie RPE.

Très avantageusement, le matériau dosimétrique est placé sous forme pulvérulente ou solide dans l'enveloppe 20, puisque n'étant pas manipulé après avoir été irradié, il est par exemple superflu de le mélanger à un excipient pour lui conférer une forme stable.

Alternativement, le matériau dosimétrique peut également être sous forme liquide.

Le matériau utilisé est avantageusement un acide aminé, du formate d'ammonium, du dithionate de potassium, un polymère, de l'émail dentaire, des carbohydrates, des verres minéraux, de l'os, etc. Très avantageusement, le matériau est de l'alanine, sous forme de poudre pure, c'est-à-dire sans excipient.

Dans tous les cas, l'utilisation de matériau dosimétrique sous forme pure est rendue possible par l'absence de transvasement du matériau entre l'irradiation et la mesure. Cela rend en outre possible de miniaturiser le dosimètre, puisque ses dimensions ne sont plus contraintes par la taille des pastilles d'alanine utilisées dans l'art antérieur.

Ainsi, le dosimètre peut avantageusement être conformé pour présenter des dimensions analogues ou inférieures aux dimensions des faisceaux de rayonnements ionisants utilisés par exemple en médecine. Ainsi par exemple, le dosimètre peut présenter une forme cylindrique ou sphérique de diamètre compris entre 0 et 5 mm, et avantageusement inférieur à 2 mm.

La forme du dosimètre n'est cependant pas limitée à une telle forme ; il peut alternativement être parallélépipédique, ou de toute autre forme désirée.

Concernant l'enveloppe d'autre part, elle est avantageusement réalisée en un matériau étanche aux liquides et aux gaz. Ceci permet par exemple de positionner le dosimètre dans une cuve à eau utilisée couramment pour l'étalonnage et la vérification de la précision de dispositifs d'irradiation utilisés à des fins médicales. Ceci permet également d'éviter l'interaction du matériau dosimétrique avec l'ozone produit dans l'air lors de l'irradiation, qui peut affecter la réponse du dosimètre. Ceci permet également d'envisager d'utiliser des matériaux dosimétriques dont la décroissance du signal RPE est liée à l'interaction avec l'eau ou l'oxygène par exemple.

Dans ce cas, le dosimètre est avantageusement miniaturisé pour présenter des dimensions de l'ordre du faisceau d'irradiation utilisées, c'est-à-dire de l'ordre du millimètre.

Le matériau constitutif de l'enveloppe est en outre avantageusement un matériau biocompatible au sens de la norme ISO10-993 ou pouvant être placé dans un organisme vivant le temps d'une irradiation sans interagir avec le milieu vivant ou sans y causer de dommage. C'est le cas par exemple de matériaux comme la résine dentaire ou le polycaprolactone.

Ceci permet de placer un dosimètre dans un organisme irradié par la suite, par exemple pour des raisons thérapeutiques ou pour des expérimentations de radiobiologie. La mesure in vivo de la dose reçue par le matériau dosimétrique permet de contrôler la dose reçue par l'organisme à l'emplacement où se trouve le dosimètre.

Enfin, comme visible sur la figure 2b, l'enveloppe 20 comprend avantageusement un marquage gravé ou imprimé ou un insert radio-opaque 29, par exemple métallique, qui peut être amovible ou qui présente avantageusement une réponse en spectroscopie RPE distincte de celle du matériau dosimétrique pour pouvoir les différencier lors de la mesure.

Un marquage peut être par exemple une graduation, permettant de positionner très précisément le dosimètre.

Un insert radio-opaque permet également de visualiser par imagerie radiologique la position du dosimètre lorsqu'il est inséré dans un milieu opaque, par exemple dans un organisme vivant.

Afin d'assurer que le matériau dosimétrique soit contenu hermétiquement dans l'enveloppe du dosimètre, plusieurs structures de l'enveloppe peuvent être réalisées.

Selon un premier mode de réalisation, représenté en figure 2a, l'enveloppe 20 est réalisée en deux parties 22, 24 conformées pour coopérer ensemble afin de former l'enveloppe hermétique.

Ainsi une partie 22 peut être une partie femelle adaptée pour recevoir une partie mâle 24 dont la protubérance 25 peut être creuse, afin de définir le volume 21 intérieur de l'enveloppe une fois celle-ci fermée.

Les parties 22 et 24 peuvent être solidarisées ensemble par tout moyen. Par exemple par emboîtage élastique (clipsage), si l'une des deux parties présente sur une surface extérieure une rainure adaptée pour recevoir un bourrelet complémentaire de l'autre partie.

Les parties 22 et 24 peuvent également être vissées comme sur la figure 2a, en présentant à cet égard des filetages 26, 28 complémentaires.

Les parties 22 et 24 peuvent également être collées (par ajout de matière, en particulier de colle) ou soudées (pas d'ajout de matière mais fusion locale du matériau formant l'enveloppe d'au moins une partie pour adhérer à l'autre partie) ensemble.

Les parties 22 et 24 peuvent également être solidarisées par serrage, par exemple de type glissement cône-cône entre une protubérance mâle en tronc de cône et un logement femelle complémentaire, en tronc de cône également.

Selon un mode de réalisation alternatif représenté en figure 2b, l'enveloppe peut être réalisée d'une seule pièce en un matériau ductile, par exemple de la cire, permettant d'insérer la quantité de matériau dosimétrique dans une enveloppe préformée, puis de déformer l'enveloppe pour la refermer sur le matériau dosimétrique. Alternativement, le matériau dosimétrique peut être injecté directement dans l'enveloppe, celle-ci pouvant être ensuite déformée pour fermer un trou consécutif à l'injection. Dans encore une autre variante, un trou d'injection peut être prévu initialement dans une partie de l'enveloppe, ce trou étant ensuite bouché soit par une partie complémentaire, soit en fondant localement le matériau de l'enveloppe autour du trou.

Il est donc important que le matériau utilisé pour réaliser l'enveloppe 20 soit un matériau formable, c'est-à-dire un matériau pouvant être moulé, ou injecté, puis le cas échéant usiné, car ainsi il rend possible la formation de dosimètres de toutes formes et toutes dimensions possibles. En particulier, le dosimètre peut être d'une taille de l'ordre du millimètre, voire inférieure, ce qui permet une précision accrue des mesures de doses dans un emplacement défini.

Un matériau préféré pour réaliser l'enveloppe 20 du dosimètre est le polycaprolactone (ou PCL). Ce matériau comporte l'avantage de présenter un signal RPE qui décroît dans le temps jusqu'à disparaître en environ 1000 minutes après une irradiation.

De plus, l'intensité du signal RPE du PCL après irradiation est diminuée si le PCL a auparavant subi une pré-irradiation, avantageusement d'au moins 300 Gy. Il est donc avantageux de réaliser une pré-irradiation du matériau avant de l'utiliser en tant qu'enveloppe 20 du dosimètre, car alors l'intensité du signal RPE après l'irradiation est moindre que si le matériau n'avait pas été pré-irradié, et d'éventuels signaux RPE parasites du PCL sont supprimés.

En outre ce matériau peut être moulé, ce qui permet de conférer au dosimètre n'importe quelle forme, et également de fermer l'enveloppe 20 en la scellant au moyen d'une quantité de matériau fondu.

En référence à la figure 4, on a représenté les principales étapes d'un procédé 1000 de dosimétrie par spectroscopie RPE conforme à l'invention.

Ce procédé permet de mesurer la dose absorbée par le matériau dosimétrique contenu dans un dosimètre précédemment décrite, une fois que ledit dosimètre a été irradié à une dose inconnue.

Une première étape 100 du procédé consiste à effectuer une mesure par spectroscopie RPE d'un dosimètre 1 pour obtenir un spectre RPE dudit dosimètre. Cette étape est une étape classique de spectroscopie RPE consistant à placer le dosimètre dans un champ magnétique B et dans un champ électromagnétique E orthogonal, et à faire varier l'intensité du champ magnétique ou la fréquence (soit l'énergie) des ondes électromagnétiques pour obtenir le spectre.

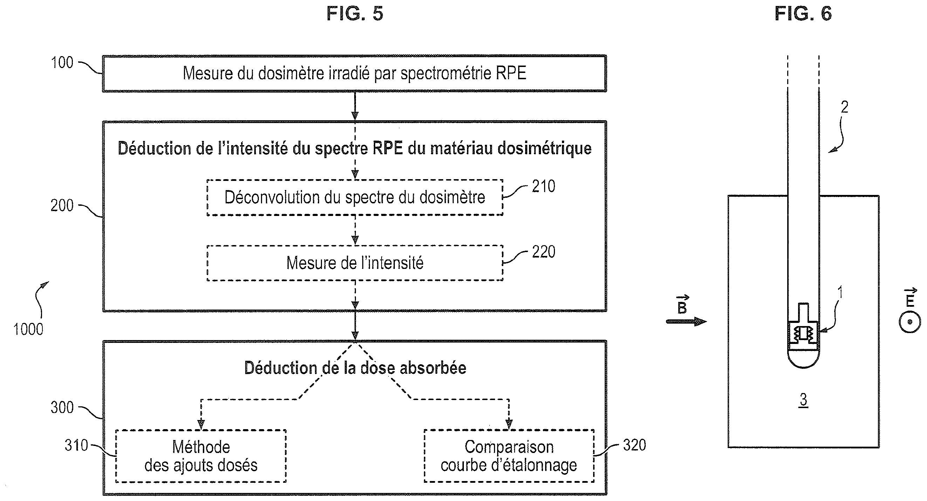

Comme représenté en figure 6, il suffit de placer le dosimètre irradié dans un support 2 prévu à cet effet, et de mettre le support 2 dans la cavité résonante 3 d'un spectromètre RPE (non représenté sur la figure) le support n'impactant pas la mesure puisqu'il n'a pas été irradié.

Puis, le procédé comprend une étape 200 consistant à déduire du spectre RPE du dosimètre l'intensité du spectre RPE du matériau dosimétrique qu'il contient, c'est-à-dire par exemple l'amplitude de la raie RPE du matériau dosimétrique.

Pour ce faire, plusieurs modes de réalisation sont envisageables. Selon un premier mode de réalisation, le matériau de l'enveloppe du dosimètre ne présente pas de signal RPE au moment de la mise en œuvre du procédé de mesure. Ceci est le cas quand le matériau ne présente jamais de signal RPE après irradiation, ou lorsqu'il présente une réponse décroissante et que la mesure est réalisée après un laps de temps ΔT au terme duquel l'amplitude du spectre RPE du matériau est nulle ou constante, c'est-à-dire où l'amplitude pic à pic de la raie RPE du matériau est nulle.

Dans ce cas, le signal RPE du dosimètre correspond au signal RPE du matériau dosimétrique, et on peut mesurer l'intensité du signal du matériau dosimétrique en mesurant l'intensité du signal RPE du dosimètre.

Ainsi selon le mode de réalisation où on mesure l'amplitude pic-à-pic de la raie RPE du matériau dosimétrique, cette amplitude correspond à celle de la raie RPE du dosimètre.

Alternativement, le matériau de l'enveloppe du dosimètre présente une raie RPE s'étendant sur une plage d'énergies/fréquences des ondes électromagnétiques ou d'intensités de champ magnétique distincte de celle de la raie RPE du matériau dosimétrique.

Dans ce cas, connaissant la réponse par spectroscopie RPE du matériau dosimétrique que l'on étudie, il suffit de mesurer l'amplitude pic-à-pic du spectre RPE du dosimètre au niveau d'énergie/fréquence des ondes électromagnétiques ou au niveau d'intensité du champ magnétique correspondant au pic d'absorption du matériau dosimétrique.

Enfin, dans le cas où il n'est pas possible de distinguer le spectre RPE de l'enveloppe du dosimètre du spectre du matériau dosimétrique, l'étape 200 comprend une sous-étape 210 de déconvolution du spectre RPE du dosimètre pour obtenir le spectre RPE du matériau dosimétrique. On peut ensuite au cours d'une sous-étape 220 mesurer l'intensité du spectre RPE du matériau dosimétrique.

Le procédé 1000 comprend enfin une étape 300 consistant à déduire, de l'intensité du signal RPE mesurée (par exemple de l'amplitude pic-à-pic de la raie RPE), une valeur de dose absorbée par le matériau dosimétrique.

Pour ce faire, on peut, selon un premier mode de réalisation, mettre en œuvre la méthode 310 par « ajouts dosés », au cours de laquelle on soumet le dosimètre à des irradiations supplémentaires à des doses connues, et comme précédemment on effectue une mesure par spectroscopie RPE du dosimètre à chaque irradiation supplémentaire pour en déduire l'intensité du signal RPE du matériau dosimétrique pour chaque ajout de dose.

On mesure ensuite, à chaque variation de dose apportée au dosimètre, la variation d'intensité en résultant sur les spectres RPE du matériau dosimétrique, pour en déduire un coefficient de sensibilité du dosimètre (indiquant la variation d'intensité en fonction de la variation de dose) permettant d'extrapoler, pour une intensité donnée du signal RPE du matériau dosimétrique, la dose reçue initialement.

Alternativement, on utilise une courbe d'étalonnage préalablement réalisée à l'aide de dosimètres identiques à celui qu'on étudie, cette courbe d'étalonnage ayant été réalisée en irradiant ces dosimètres à plusieurs doses connues et en mesurant l'amplitude du spectre RPE du matériau dosimétrique pour chaque dose.

L'étape 300 comprend alors la comparaison 320 de l'amplitude à la courbe d'étalonnage et la déduction de la dose correspondante.

Le procédé proposé permet donc de mesurer la dose absorbée par le matériau dosimétrique plus rapidement puisqu'il n'est pas nécessaire de le transvaser pour effectuer la mesure.

En outre, cette mesure est plus précise puisqu'il n'y a aucun risque de perdre le matériau au cours de manipulations, et puisqu'il n'est pas nécessaire de recourir à un excipent pour conférer au matériau dosimétrique une consistance solide, l'excipient pouvant dégrader la précision de la mesure comme expliqué précédemment.

## Revendications

1. Dosimètre (1) de radiations pour spectroscopie RPE, comprenant une quantité d'un matériau dosimétrique, le dosimètre étant adapté pour être irradié et subir une mesure de dose par spectroscopie RPE,
le dosimètre comprenant en outre une enveloppe (20) fermée contenant hermétiquement ledit matériau dosimétrique (10), l'enveloppe (20) étant réalisée d'une seule pièce en matériau ductile ou étant constituée de deux parties d'enveloppe (22, 24) conformées pour coopérer ensemble,
l'enveloppe (20) étant réalisée en un matériau ne présentant pas de réponse par spectroscopie RPE ou présentant une réponse par spectroscopie RPE différente de la réponse du matériau dosimétrique (10) après une irradiation identique, telle que le signal mesuré par spectroscopie RPE du matériau de l'enveloppe (20) décroît en fonction du temps après une irradiation dudit matériau de l'enveloppe,
de sorte qu'il existe un laps de temps après irradiation au terme duquel le matériau de l'enveloppe ne présente pas de signal RPE mesurable, ou présente un signal résiduel dont l'intensité est inférieure à 5% de celui mesuré après irradiation, et le matériau dosimétrique (10) présente un signal RPE constant en fonction du temps après une irradiation dudit matériau dosimétrique.

2. Dosimètre (1) selon la revendication 1, dans lequel le matériau dosimétrique (10) est sous forme pulvérulente, solide ou liquide.

3. Dosimètre (1) selon l'une des revendications précédentes, dans lequel le matériau de l'enveloppe (20) est un matériau étanche aux liquides et aux gaz.

4. Dosimètre (1) selon l'une des revendications précédentes, dans lequel le matériau de l'enveloppe (20) est un matériau biocompatible au sens de la norme ISO10-993.

5. Dosimètre (1) selon l'une des revendications précédentes, dans lequel l'enveloppe (20) comporte en outre un marquage gravé ou imprimé, ou un insert radio-opaque (29).

6. Dosimètre (1) selon l'une des revendications précédentes, dans lequel le matériau de l'enveloppe (20) est du polycaprolactone ou du polycarbonate.

7. Dosimètre (1) selon l'une des revendications précédentes, les signaux RPE du matériau dosimétrique (10) et du matériau de l'enveloppe (20) comprenant chacun une raie d'absorption d'énergie électromagnétique en fonction d'un champ magnétique appliqué au matériau, les raies d'absorption du matériau dosimétrique (10) et du matériau de l'enveloppe (20) s'étendant respectivement sur :
- des plages d'énergies distinctes à champ magnétique identique, ou
- des plages de champs magnétiques distinctes à énergie électromagnétique identique.

8. Dosimètre (1) selon l'une des revendications précédentes, dans lequel le matériau dosimétrique (10) est choisi parmi le groupe suivant: alanine, os, carbohydrates, formate d'ammonium, dithionate de potassium, verres minéraux, émail dentaire, dentine, polymères.

9. Dosimètre (1) selon l'une des revendications précédentes, dans lequel le matériau dosimétrique (10) est pur.

10. Procédé de mesure par spectroscopie RPE d'une dose absorbée par une quantité de matériau dosimétrique (10) contenue dans un dosimètre (1) selon l'une des revendications précédentes,
ledit dosimètre (1) ayant été irradié avec une dose inconnue, le procédé étant mis en œuvre après le laps de temps écoulé après l'irradiation du dosimètre (1) au terme duquel le matériau de l'enveloppe ne présente pas de signal RPE, le signal RPE du dosimètre (1) correspondant alors au signal RPE du matériau dosimétrique (10), et comprenant les étapes consistant à :
- mettre en œuvre une mesure par spectroscopie RPE d'un dosimètre (1) selon l'une des revendications précédentes pour obtenir un signal RPE du dosimètre,
- déduire du signal RPE du dosimètre (1) l'intensité du signal RPE du matériau dosimétrique (10), et
- déduire de l'intensité du signal RPE du matériau dosimétrique (10) une dose absorbée par ledit matériau lors d'une irradiation.

11. Procédé de mesure selon la revendication précédente, dans lequel la déduction de l'intensité du signal RPE du matériau dosimétrique à partir du signal RPE du dosimètre comprend l'obtention du signal RPE du matériau dosimétrique (10) par déconvolution du signal RPE du dosimètre (1) et la mesure de l'intensité du signal RPE du matériau dosimétrique (10).

12. Procédé de mesure selon l'une des revendications 10 ou 11, dans lequel le matériau de l'enveloppe (20) a subi une pré-irradiation avant l'irradiation du dosimètre.

13. Procédé de mesure selon l'une des revendications 10 à 12, dans lequel la déduction de la dose absorbée par le matériau dosimétrique comprend les étapes consistant à :
- irradier le dosimètre (1) à une pluralité de doses connues, et à chaque irradiation, mettre en œuvre une mesure par spectroscopie RPE du dosimètre, et déduire du signal obtenu un signal RPE du matériau dosimétrique (10),
- déterminer un coefficient de sensibilité du dosimètre (1), et
- extrapoler, à partir des intensités des signaux RPE du matériau dosimétrique, la dose absorbée par le dosimètre.

14. Utilisation d'un procédé d'étalonnage pour étalonner un dosimètre (1) selon l'une des revendications 1 à 9, comprenant l'irradiation du dosimètre (1) à une pluralité de doses connues, et la mise en œuvre, à chaque irradiation, d'une mesure par spectroscopie RPE de l'intensité du signal RPE du dosimètre (1), pour établir une relation entre la valeur de l'intensité dudit signal et la dose reçue.

15. Procédé de fabrication d'un dosimètre selon l'une des revendications 1 à 9, comprenant :
- la formation d'une enveloppe (20), par moulage, injection ou usinage,
- l'insertion de matériau dosimétrique (10) dans une partie de l'enveloppe, et
- la fermeture hermétique de l'enveloppe (20), l'enveloppe (20) obtenue étant réalisée d'une seule pièce en matériau ductile ou étant constituée de deux parties d'enveloppe (22, 24) conformées pour coopérer ensemble.

## Patentansprüche

1. Strahlungsdosimeter (1) für EPR-Spektroskopie, das eine Menge eines Dosimetermaterials umfasst, wobei das Dosimeter angepasst ist, um bestrahlt zu werden und einer Dosismessung durch EPR-Spektroskopie unterzogen zu werden,
wobei das Dosimeter ferner eine geschlossene Hülle (20) umfasst, die hermetisch das Dosimetermaterial (10) enthält, wobei die Hülle (20) einstückig aus einem duktilen Material hergestellt ist oder aus zwei Hüllenteilen (22, 24) besteht, die angepasst sind, um miteinander zusammenzuwirken,
wobei die Hülle (20) aus einem Material hergestellt ist, das nach einer identischen Bestrahlung keine Reaktion durch EPR-Spektroskopie aufweist oder eine Reaktion durch EPR-Spektroskopie aufweist, die sich von der Reaktion des Dosimetermaterials (10) unterscheidet, derart dass das durch EPR-Spektroskopie gemessene Signal des Materials der Hülle (20) nach einer Bestrahlung des Materials der Hülle in Abhängigkeit von der Zeit abnimmt,
derart dass ein Zeitraum nach der Bestrahlung vorhanden ist, an dessen Ende das Material der Hülle kein messbares EPR-Signal aufweist oder ein Restsignal aufweist, dessen Stärke kleiner als 5% des nach der Bestrahlung gemessenen ist, und das Dosimetermaterial (10) nach einer Bestrahlung des Dosimetermaterials ein zeitkonstantes EPR-Signal aufweist.

2. Dosimeter (1) nach Anspruch 1, wobei das Dosimetermaterial (10) in Pulver-, fester oder flüssiger Form vorliegt.

3. Dosimeter (1) nach einem der vorhergehenden Ansprüche, wobei das Material der Hülle (20) ein gegenüber Flüssigkeiten und gegenüber Gasen dichtes Material ist.

4. Dosimeter (1) nach einem der vorhergehenden Ansprüche, wobei das Material der Hülle (20) ein im Sinne der Norm ISO10-993 biokompatibles Material ist.

5. Dosimeter (1) nach einem der vorhergehenden Ansprüche, wobei die Hülle (20) ferner eine gravierte oder gedruckte Markierung oder einen strahlungsundurchlässigen Einsatz (29) umfasst.

6. Dosimeter (1) nach einem der vorhergehenden Ansprüche, wobei das Material der Hülle (20) Polycaprolacton oder Polycarbonat ist.

7. Dosimeter (1) nach einem der vorhergehenden Ansprüche, wobei die EPR-Signale des Dosimetermaterials (10) und des Materials der Hülle (20) jeweils eine Linie zur Absorption elektromagnetischer Energie in Abhängigkeit von einem auf das Material angewandten Magnetfeld umfasst, wobei die Absorptionslinien des Dosimetermaterials (10) und des Materials der Hülle (20) sich erstrecken über:
- unterschiedliche Energiebereiche bei identischem Magnetfeld, beziehungsweise
- unterschiedliche Energiebereiche bei identischer elektromagnetischer Energie.

8. Dosimeter (1) nach einem der vorhergehenden Ansprüche, wobei das Dosimetermaterial (10) aus der folgenden Gruppe ausgewählt ist: Alanin, Knochen, Kohlenhydrate, Ammoniumformiat, Kaliumdithionat, Mineralgläser, Zahnschmelz, Dentin, Polymeren.

9. Dosimeter (1) nach einem der vorhergehenden Ansprüche, wobei das Dosimetermaterial (10) rein ist.

10. Verfahren zur Messung einer Dosis, die durch eine Menge an Dosimetermaterial (10) absorbiert wird, die in einem Dosimeter (1) nach einem der vorhergehenden Ansprüche enthalten ist, durch EPR-Spektroskopie,
wobei das Dosimeter (1) mit einer unbekannten Dosis bestrahlt wurde, das Verfahren nach einem Zeitraum durchgeführt wird, der nach der Bestrahlung des Dosimeters (1) verstrichen ist und an dessen Ende das Material der Hülle kein EPR-Signal aufweist, wobei das EPR-Signal des Dosimeters (1) dann dem EPR-Signal des Dosimetermaterials (10) entspricht, und das die Schritte umfasst, die bestehen aus:
- Durchführen einer Messung eines Dosimeters (1) nach einem der vorhergehenden Ansprüche durch EPR-Spektroskopie, um ein EPR-Signal des Dosimeters zu erhalten,
- Ableiten der Stärke des EPR-Signals des Dosimetermaterials (10) von dem EPR-Signal des Dosimeters (1), und
- Ableiten einer durch das Material bei einer Bestrahlung absorbierten Dosis von der Stärke des EPR-Signals des Dosimetermaterials (10).

11. Messverfahren nach dem vorhergehenden Anspruch, wobei die Ableitung der Stärke des EPR-Signals des Dosimetermaterials ausgehend von dem EPR-Signal des Dosimeters den Erhalt des EPR-Signals des Dosimetermaterials (10) durch Dekonvolution des EPR-Signals des Dosimeters (1) und der Messung der Stärke des ERP-Signals des Dosimetermaterials (10) umfasst.

12. Messverfahren nach einem der Ansprüche 10 oder 11, wobei das Material der Hülle (20) vor der Bestrahlung des Dosimeters eine Vorbestrahlung erfahren hat.

13. Messverfahren nach einem der Ansprüche 10 bis 12, wobei die Ableitung der durch das Dosimetermaterial absorbierten Dosis die Schritte umfasst, die bestehen aus:
- Bestrahlen des Dosimeters (1) mit einer Vielzahl von bekannten Dosen und, bei jeder Bestrahlung, Durchführen einer EPR-Spektroskopiemessung des Dosimeters und Ableiten eines EPR-Signals des Dosimetermaterials (10) von dem erhaltenen Signal,
- Bestimmen eines Empfindlichkeitskoeffizienten des Dosimeters (1), und
- Extrapolieren der durch das Dosimeter absorbierten Dosis ausgehend von den Stärken der EPR-Signale des Dosimetermaterials.

14. Verwendung eines Eichungsverfahrens zum Eichen eines Dosimeters (1) nach einem der Ansprüche 1 bis 9, das die Bestrahlung des Dosimeters (1) mit einer Vielzahl von bekannten Dosen und das Durchführen einer EPR-Spektroskopiemessung der Stärke des EPR-Signals des Dosimeters (1) bei jeder Bestrahlung umfasst, um eine Beziehung zwischen dem Wert der Stärke des Signals und der empfangenen Dosis festzulegen.

15. Verfahren zur Herstellung eines Dosimeters nach einem der Ansprüche 1 bis 9, das umfasst:
- die Bildung einer Hülle (20) durch Formen, Spritzen oder Bearbeiten,
- die Einführung von Dosimetermaterial (10) in einen Teil der Hülle, und
- das hermetische Schließen der Hülle (20), wobei die erhaltene Hülle (20) einstückig aus duktilem Material hergestellt wird oder aus zwei Hüllenteilen (22, 24) besteht, die angepasst sind, um miteinander zusammenzuwirken.

## Claims

1. Radiation dosimeter (1) for EPR spectroscopy, comprising a quantity of a dosimetric material, the dosimeter being suitable for being irradiated and undergoing a dose measurement by EPR spectroscopy,
the dosimeter further comprising a closed enclosure (20) hermetically containing said dosimetric material (10), the enclosure (20) being made of a single piece of ductile material or consisting of two enclosure parts (22, 24) shaped to cooperate together,
the enclosure (20) being made of a material that does not have any response by EPR spectroscopy or that has a response by EPR spectroscopy that is different from the response of the dosimetric material (10) after identical irradiation, such that the signal measured by EPR spectroscopy of the material of the enclosure (20) decays as a function of time after irradiation of said enclosure material,
such that there is a period of time after irradiation at the end of which the enclosure material does not have a measurable EPR signal, or has a residual signal the intensity of which is less than 5% of that measured after irradiation, and the dosimetric material (10) has a constant EPR signal as a function of time after irradiation of said dosimetric material.

2. The dosimeter (1) as claimed in claim 1, wherein the dosimetric material (10) is in powder, solid or liquid form.

3. The dosimeter (1) as claimed in one of the preceding claims, wherein the material of the enclosure (20) is a material that is sealed from liquids and gases.

4. The dosimeter (1) as claimed in one of the preceding claims, wherein the material of the enclosure (20) is a biocompatible material within the meaning of the standard ISO10-993.

5. The dosimeter (1) as claimed in one of the preceding claims, wherein the enclosure (20) further comprises an etched or printed marking or a radio-opaque insert (29).

6. The dosimeter (1) as claimed in one of the preceding claims, wherein the material of the enclosure (20) is polycaprolactone or polycarbonate.

7. The dosimeter (1) as claimed in one of the preceding claims, the EPR signals of the dosimetric material (10) and of the material of the enclosure (20) each comprising an absorption line of electromagnetic energy as a function of a magnetic field applied to the material, the absorption lines of the dosimetric material (10) and of the material of the enclosure (20) extending respectively over:
- separate ranges of energies with an identical magnetic field, or
- separate ranges of magnetic fields with identical electromagnetic energy.

8. The dosimeter (1) as claimed in one of the preceding claims, wherein the dosimetric material (10) is selected from the following group: alanine, bone, carbohydrates, ammonium formate, potassium dithionate, mineral glasses, dental enamel, dentine, polymers.

9. The dosimeter (1) as claimed in one of the preceding claims, wherein the dosimetric material (10) is pure.

10. Method for measuring by EPR spectroscopy a dose absorbed by a quantity of dosimetric material (10) contained in a dosimeter (1) as claimed in one of the preceding claims,
said dosimeter (1) having been irradiated with an unknown dose, the method being implemented after the period of time after irradiation of the dosimeter (1) at the end of which the enclosure material does not have an EPR signal, the EPR signal of the dosimeter (1) then corresponding to the EPR signal of the dosimetric material (10), and comprising steps of:
- implementing a measurement by EPR spectroscopy of a dosimeter (1) as claimed in one of the preceding claims to obtain an EPR signal of the dosimeter,
- deducing from the EPR signal of the dosimeter (1) the intensity of the EPR signal of the dosimetric material (10), and
- deducing from the intensity of the EPR signal of the dosimetric material (10) a dose absorbed by said material during irradiation.

11. The measurement method as claimed in the preceding claim, wherein the deducing of the intensity of the EPR signal of the dosimetric material from the EPR signal of the dosimeter comprises obtaining the EPR signal of the dosimetric material (10) by deconvolution of the EPR signal of the dosimeter (1) and measuring the intensity of the EPR signal of the dosimetric material (10) .

12. The measurement method as claimed in one of claims 10 or 11, wherein the enclosure material (20) has been subjected to pre-irradiation before the irradiation of the dosimeter.

13. The measurement method as claimed in one of claims 10 to 12, wherein the deducing of the dose absorbed by the dosimetric material comprises steps of:
- irradiating the dosimeter (1) at a plurality of known doses, and at each irradiation, implementing a measurement by EPR spectroscopy of the dosimeter, and deducing from the signal obtained an EPR signal of the dosimetric material (10),
- determining a sensitivity coefficient of the dosimeter (1), and
- extrapolating, using the intensities of the EPR signals of the dosimetric material, the dose absorbed by the dosimeter.

14. Use of a calibration method for calibrating a dosimeter (1) as claimed in one of claims 1 to 9, comprising irradiating the dosimeter (1) at a plurality of known doses, and implementing, at each irradiation, a measurement by EPR spectroscopy of the intensity of the EPR signal of the dosimeter (1), to determine a relationship between the value of the intensity of said signal and the dose received.

15. Method for manufacturing a dosimeter as claimed in one of claims 1 to 9, comprising:
- the formation of an enclosure (20), by molding, injection or machining,
- the insertion of dosimetric material (10) into a portion of the enclosure, and
- the hermetic sealing of the enclosure (20), the enclosure (20) obtained being made in one piece of ductile material or consisting of two enclosure parts (22, 24) shaped to cooperate together.
